(19) Europäisches Patentamt
European Patent Office
Office européen des brevets

(11) **EP 4 693 894 A1**

(12) **EUROPEAN PATENT APPLICATION**
published in accordance with Art. 153(4) EPC

(43) Date of publication:
**11.02.2026 Bulletin 2026/07**

(21) Application number: **24779557.8**

(22) Date of filing: **15.03.2024**

(51) International Patent Classification (IPC):
*H02S 50/00* (2014.01)     *G01R 31/50* (2020.01)
*G01R 31/52* (2020.01)     *G01R 31/56* (2020.01)
*H01L 31/043* (2014.01)

(52) Cooperative Patent Classification (CPC):
**G01R 31/50; G01R 31/52; G01R 31/56;**
**H02S 50/00; H10F 19/40; Y02E 10/50**

(86) International application number:
**PCT/JP2024/010161**

(87) International publication number:
**WO 2024/203428 (03.10.2024 Gazette 2024/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **31.03.2023 JP 2023057203**

(71) Applicant: **Kaneka Corporation**
**Osaka-shi, Osaka 530-8288 (JP)**

(72) Inventors:
• **NAKAMURA Junichi**
  **Settsu-shi, Osaka 566-0072 (JP)**
• **TERASHITA Toru**
  **Settsu-shi, Osaka 566-0072 (JP)**
• **KOJIMA Kohei**
  **Settsu-shi, Osaka 566-0072 (JP)**

(74) Representative: **Hoffmann Eitle**
**Patent- und Rechtsanwälte PartmbB**
**Arabellastraße 30**
**81925 München (DE)**

(54) **PHOTOVOLTAIC SYSTEM AND SHORT CIRCUIT DETECTION METHOD FOR PHOTOVOLTAIC SYSTEM**

(57)     Provided is a photovoltaic system that detects a short circuit in tandem solar cell modules. A photovoltaic system 1 includes: a solar cell string 10 in which an M number of tandem solar cell modules 20 are connected; and a short circuit detection device 32. An M number of bottom-side solar cell submodules 22 constitute a series-connected, bottom-side solar cell string 12, and an M number of top-side solar cell submodules 24 constitute a series-connected, top-side solar cell string 14. The short circuit detection device 32 measures the potential difference Vps+ between a positive potential terminal of the bottom-side solar cell string 12 and a positive potential terminal of the top-side solar cell string 14, measures the potential difference Vps- between a negative potential terminal of the bottom-side solar cell string 12 and a negative potential terminal of the top-side solar cell string 14, and detects a short circuit in the tandem solar cell modules 20 if the absolute value of the potential difference Vps+ and the absolute value of the potential difference Vps- are greater than 0 V.

FIG .1

**Description**

TECHNICAL FIELD

The present invention relates to a solar power generation system and a method of detecting a short circuit in the solar power generation system.

BACKGROUND ART

A solar power generation system includes a solar cell string in which a plurality of solar cell modules are connected in series, and a power conditioner (also referred to as a power conditioning system (PCS)) that converts DC power from the solar cell string into the desired AC power or DC power. In such a solar power generation system, a ground fault may occur in the circuit of the solar cell string due to aging of a covering member of the circuit of the solar cell string.

As a ground fault detection method, a self-bias method is known. For example, Patent Document 1 discloses a method of detecting a ground fault location of a solar cell string using a self-bias method. Specifically, the positive electrode (P terminal) of the solar cell string is grounded via a detection resistor, and a first voltage, which is a voltage to ground at both ends of the detection resistor, is obtained. In addition, the negative electrode (N terminal) of the solar cell string is grounded via the detection resistor, and a second voltage, which is a voltage to ground at both ends of the detection resistor, is obtained. Then, the presence or absence of a ground fault and the location of the ground fault are detected from the first voltage and the second voltage.

In recent years, in order to improve the conversion efficiency of solar cell modules by effectively utilizing light in a wide wavelength range, tandem (multi-junction) solar cell modules in which photoelectric conversion layers having different band gaps are stacked have been known. As the photoelectric conversion layer, an inorganic thin film such as a crystalline silicon substrate or an amorphous silicon thin film, an organic thin film, an organic-inorganic hybrid thin film (for example, a perovskite thin film), and the like have been known. For example, Patent Document 2 discloses a tandem solar cell module in which two types of solar cell submodules each including a different photoelectric conversion layer are stacked.

Citation List

Patent Document

Patent Document 1: Japanese Unexamined Patent Application, Publication No. 2016-101012
Patent Document 2: Japanese Unexamined Patent Application, Publication No. 2018-157176

DISCLOSURE OF THE INVENTION

Problems to be Solved by the Invention

When the above-described tandem solar cell modules are each applied to the solar cell string of the above-described solar power generation system, it is conceivable to individually connect two types of solar cell submodules (two terminals) in series among a plurality of tandem solar cell modules (four terminals) due to a voltage difference between the two types of solar cell submodules.

In such a tandem solar cell module, there is a possibility that two types of solar cell submodules are short-circuited, and in a solar power generation system, a function of detecting a short circuit of a plurality of tandem solar cell modules in a solar cell string is required.

An object of the present invention is to provide a solar power generation system that detects a short circuit of a tandem solar cell module and a method of detecting a short circuit in a solar power generation system.

Means for Solving the Problems

A solar power generation system according to the present invention is directed to a solar power generation system which includes a solar cell string in which M number of 4-terminal tandem solar cell modules each including a bottom-side solar cell submodule and a top-side solar cell submodule are electrically connected, where M is an integer of 1 or more, and a short-circuit detection device that detects a short circuit between the bottom-side solar cell submodule and the top-side solar cell submodule in any of the M number of tandem solar cell modules of the solar cell string. In the solar cell string, M number of bottom-side solar cell submodules in the M number of tandem solar cell modules constitute a bottom-side solar cell string connected in series or in parallel, and M number of top-side solar cell submodules in the M number of tandem solar cell modules constitute a top-side solar cell string connected in series or in parallel. The short-circuit detection device performs at least one of a positive potential terminal measurement of electrically connecting a positive potential terminal of the bottom-side solar cell string and a positive potential terminal or a negative potential terminal of the top-side solar cell string and measuring a potential difference Vps+ between these terminals, or a negative potential terminal measurement of electrically connecting a negative potential terminal of the bottom-side solar cell string and the negative potential terminal or the positive potential terminal of the top-side solar cell string and measuring a potential difference Vps- between these terminals. The short-circuit detection device further detects, when at least one of an absolute value of the potential difference Vps+ or an absolute value of the potential difference Vps- is larger than 0 V, a short circuit between the bottom-side solar cell submodule and the top-side solar cell submodule in any of the M number of tandem solar cell modules.

In a method of detecting a short circuit in a solar power generation system according to the present invention, the solar power generation system includes a solar cell string in which M number of 4-terminal tandem solar cell modules each including a bottom-side solar cell submodule and a top-side solar cell submodule are electrically connected. In the solar cell string, M number of bottom-side solar cell submodules in the M number of tandem solar cell modules constitute a bottom-side solar cell string connected in series or in parallel, and M number of top-side solar cell submodules in the M number of tandem solar cell modules constitute a top-side solar cell string connected in series or in parallel, where M is an integer of 1 or more. The method includes: performing at least one of a positive potential terminal measurement of electrically connecting a positive potential terminal of the bottom-side solar cell string and a positive potential terminal or a negative potential terminal of the top-side solar cell string and measuring a potential difference Vps+ between these terminals, or a negative potential terminal measurement of electrically connecting a negative potential terminal of the bottom-side solar cell string and a negative potential terminal or the positive potential terminal of the top-side solar cell string and measuring a potential difference Vps- between these terminals; and detecting, when at least one of an absolute value of the potential difference Vps+ or an absolute value of the potential difference Vps- is larger than 0 V, a short circuit between the bottom-side solar cell submodule and the top-side solar cell submodule in any of the M number of tandem solar cell modules.

Effects of the Invention

According to the present invention, it is possible to detect a short circuit of a tandem solar cell module in a solar power generation system.

BRIEF DESCRIPTION OF THE DRAWINGS

FIG. 1 is a schematic diagram showing a configuration of a solar power generation system according to a first embodiment.
FIG. 2 is a schematic diagram showing a configuration of a short-circuit detection device 32 in a power conditioner 30 of the solar power generation system 1 shown in FIG. 1.
FIG. 3 is a diagram showing a solar cell string in the solar power generation system shown in FIG. 1.
FIG. 4 is a diagram showing a solar cell string in the solar power generation system shown in FIG. 1.
FIG. 5 is a diagram showing a solar cell string in the solar power generation system shown in FIG. 1.
FIG. 6 is a diagram showing a solar cell string in the solar power generation system shown in FIG. 1.
FIG. 7 is a schematic diagram showing a configuration of a solar power generation system according to a second embodiment.
FIG. 8 is a diagram showing a solar cell string in the solar power generation system shown in FIG. 7.
FIG. 9 is a diagram showing a solar cell string in the solar power generation system shown in FIG. 7.

PREFERRED MODE FOR CARRYING OUT THE INVENTION

Hereinafter, an example of an embodiment of the present invention will be described with reference to the drawings. In the drawings, the same or corresponding parts are denoted by the same reference numerals. For convenience, hatching, a reference sign of a member, and the like may be omitted, and in this case, another drawing is referenced.

[First Embodiment]

(Solar Power Generation System)

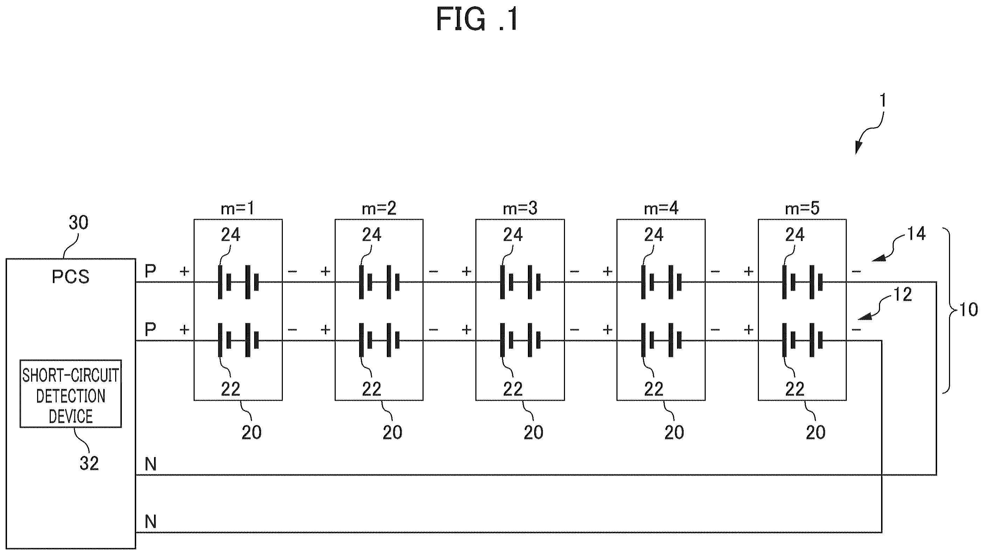

FIG. 1 is a schematic diagram showing a configuration of a solar power generation system according to a first embodiment. As shown in FIG. 1, the solar power generation system 1 includes a solar cell string 10 and a power conditioner (power conditioning system: PCS) 30.

The solar cell string 10 includes M number of solar cell modules 20 (M is an integer of 1 or more) electrically connected between two positive potential terminals P and two negative potential terminals N. Hereinafter, each of the M number of solar cell modules 20 may be referred to as an m-th solar cell module from the positive potential terminal P side of the solar cell string 10 (m is an integer of 1 or more and M or less).

Each of the solar cell modules 20 is a tandem solar cell module in which a bottom-side solar cell submodule 22 and a top-side solar cell submodule 24 are stacked, and is a four terminal solar cell module. In each of the solar cell modules 20, the bottom-side solar cell submodule 22 is electrically insulated from the top-side solar cell submodule 24.

In the solar cell string 10, M number of bottom-side solar cell submodules 22 of M number of solar cell modules 20 constitute a bottom-side solar cell string 12 connected in series between one positive potential terminal P and one negative potential terminal N, and M number of top-side solar cell submodules 24 of M number of solar cell modules 20 constitute a top-side solar cell string 14 connected in series between the other positive potential terminal P and the other negative potential terminal N.

The bottom-side solar cell submodule 22 includes a plurality of solar battery cells (or solar panels) connected in series, and the top-side solar cell submodule 24 includes a plurality of solar battery cells (or solar panels) connected in series.

Examples of the solar battery cells in the bottom-side solar cell submodules 22 and the top-side solar cell submodules 24 include thin-film solar cells such as amorphous silicon-based or perovskite-type solar cells including an inorganic semiconductor thin film, an organic semiconductor thin film, an organic-inorganic hybrid semiconductor thin film, or the like as a photoelectric conversion layer, crystalline silicon-based solar cells including a crystalline silicon substrate as a photoelectric conversion layer, and the like. For example, it is preferable that the bottom-side solar cell submodule 22 is a module including a crystalline silicon-based solar battery cell and the top-side solar cell submodule 24 is a module including a perovskite-type solar battery cell, because light in a relatively wide wavelength range can be effectively used.

The power conditioner 30 converts the DC power from the bottom-side solar cell string 12 of the solar cell string 10 into the desired AC power or DC power, converts the DC power from the top-side solar cell string 14 of the solar cell string 10 into the desired AC power or DC power, and combines the converted powers. The power conditioner 30 may have a maximum power point tracking (MPPT) function of tracking an optimal operation point (maximum power point) of output power of the bottom-side solar cell string 12 in the solar cell string 10, or may have a maximum power point tracking (MPPT) function of tracking an optimal operation point (maximum power point) of output power of the top-side solar cell string 14 in the solar cell string 10. The power conditioner 30 includes a short-circuit detection device 32.

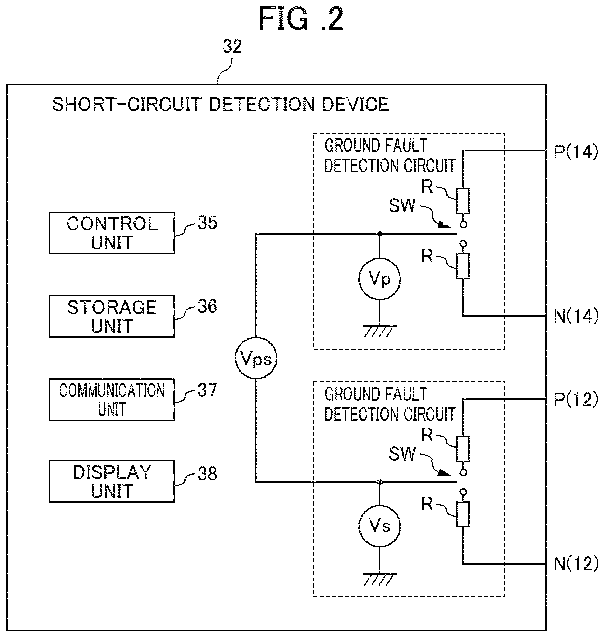

FIG. 2 is a schematic diagram showing a configuration of a short-circuit detection device 32 in the power conditioner 30 of the solar power generation system 1 shown in FIG. 1. The short-circuit detection device 32 shown in FIG. 2 detects the presence or absence of a short circuit between the bottom-side solar cell submodule 22 and the top-side solar cell submodule 24 in any of the solar cell modules 20 of the solar cell string 10. In addition, the short-circuit detection device 32 identifies (estimates) the location of the short circuit between the bottom-side solar cell submodule 22 and the top-side solar cell submodule 24 in any of the solar cell modules 20 of the solar cell string 10. The short-circuit detection device 32 includes two ground fault detection circuits, a voltmeter Vps, a control unit 35, a storage unit 36, a communication unit 37, and a display unit 38.

The two ground fault detection circuits are, for example, ground fault detection circuits using a known self-bias method (see, for example, Patent Document 1). The two ground fault detection circuits in the short-circuit detection device 32 may be ground fault detection circuits provided in the power conditioner 30.

For example, one ground fault detection circuit includes a resistor R having one end connected to the positive potential terminal P of the bottom-side solar cell string 12 of the solar cell string 10, a resistor R having one end connected to the negative potential terminal N of the bottom-side solar cell string 12 of the solar cell string 10, a voltmeter Vs, and a switch SW that selectively connects the voltmeter Vs to one of the other ends of the two resistors R. With such a configuration, the ground fault detection circuit grounds the positive potential terminal P of the bottom-side solar cell string 12 via the resistor R, and obtains the voltage Vs+, which is the voltage to ground at both ends of the resistor R. Further, the ground fault detection circuit grounds the negative potential terminal N of the bottom-side solar cell string 12 via the resistor R, and obtains a voltage Vs-, which is the voltage to ground at both ends of the resistor R. Then, the ground fault detection circuit detects the presence or absence of a ground fault of the bottom-side solar cell string 12 and the location of the ground fault from the voltage Vs+ and the voltage Vs-.

Similarly, for example, the other ground fault detection circuit includes a resistor R having one end connected to the positive potential terminal P of the top-side solar cell string 14 of the solar cell string 10, a resistor R having one end connected to the negative potential terminal N of the top-side solar cell string 14 of the solar cell string 10, a voltmeter Vp, and a switch SW that selectively connects the voltmeter Vp to one of the other ends of the two resistors R. With such a configuration, the ground fault detection circuit grounds the positive potential terminal P of the top-side solar cell string 14 via the resistor R, and obtains the voltage Vp+, which is the voltage to ground at both ends of the resistor R. Further, the ground fault detection circuit grounds the negative potential terminal N of the top-side solar cell string 14 via the resistor R, and obtains the voltage Vp-, which is the voltage to ground at both ends of the resistor R. Then, the ground fault detection circuit detects the presence or absence of a ground fault of the top-side solar cell string 14 and the location of the ground fault from the voltage Vp+ and the voltage Vp-.

The control unit 35 performs overall control of the short-circuit detection device 32. The control unit 35 of the short-circuit detection device 32 is configured by an arithmetic processor such as a central processing unit (CPU), a digital signal processor (DSP), or a field-programmable gate array (FPGA). Various functions of the control unit 35 of the short-circuit detection device 32 are realized by executing predetermined software (a program or an application) stored in the storage unit 36, for example. The various functions of the control unit 35 of the short-circuit detection device 32 may be realized by cooperation of hardware and software, or may be realized by only hardware (electronic circuit).

The storage unit 36 stores predetermined software (program, application) executed by the control unit 35 of the short-circuit detection device 32. Further, the storage unit 36 stores the measured values of the voltages of the bottom-side solar cell submodule 22 and the top-side solar cell submodule 24 in each solar cell module 20, which are measured in advance. Further, the storage unit 36 stores the number M of solar cell modules 20. The storage unit 36 is configured by rewritable memory such as read only memory (ROM), a hard disk drive (HDD), or a solid state drive (SSD).

The communication unit 37 is an interface that communicates information with the outside in accordance with a communication standard such as a wired LAN or a wireless LAN.

The display unit 38 is, for example, a notification unit that notifies a maintenance manager of information. The display unit 38 is configured by, for example, a liquid crystal display or an organic EL display.

In addition, a part of the short-circuit detection device 32, for example, one or more of the control unit 35, the storage unit 36, the communication unit 37, and the display unit 38 may be provided outside the short-circuit detection device 32, for example, in the power conditioner 30 or a host device connected to the power conditioner 30.

(Short Circuit Detection Method)

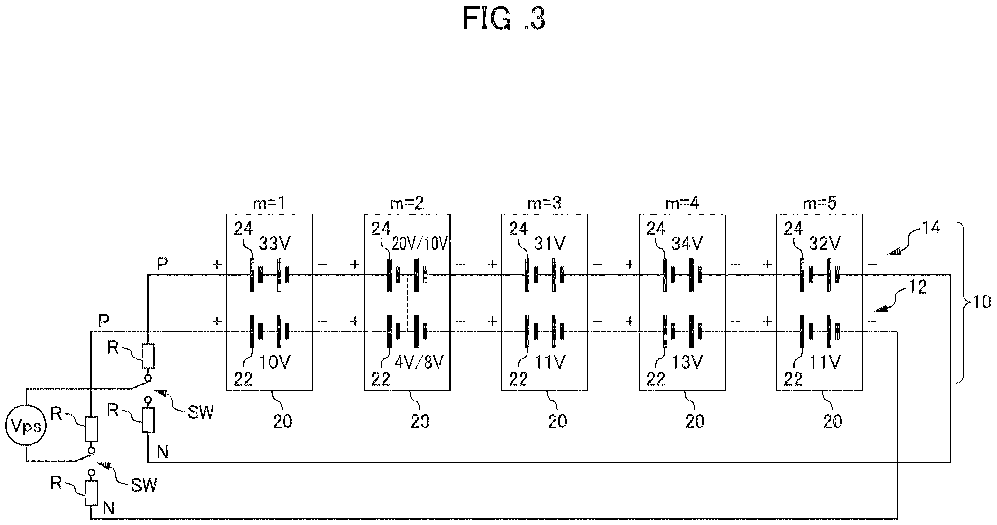

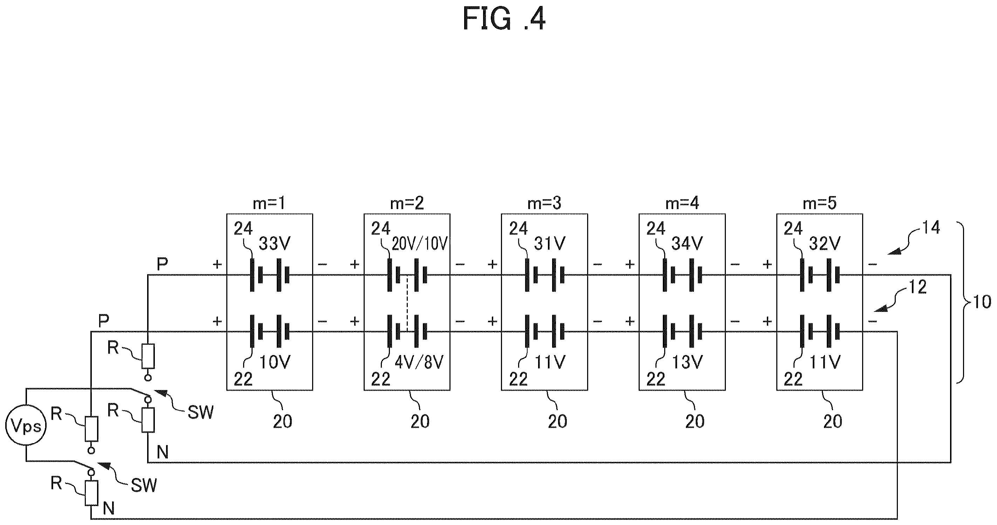

Hereinafter, a method of detecting a short circuit of the solar cell string 10 by the short-circuit detection device 32 in the method of detecting a short circuit of the solar power generation system according to the first embodiment will be described with reference to FIGS. 1 to 4. FIGS. 3 and 4 are diagrams each showing the solar cell string in the solar power generation system shown in FIG. 1.

First, as shown in FIG. 3, the short-circuit detection device 32 electrically connects the positive potential terminal P of the bottom-side solar cell string 12 and the positive potential terminal P of the top-side solar cell string 14 in the solar cell string 10 via the resistor R and the voltmeter Vps, and measures the potential difference Vps+ between these terminals PP (positive potential terminal measurement).

Next, as shown in FIG. 4, the short-circuit detection device 32 electrically connects the negative potential terminal N of the bottom-side solar cell string 12 and the negative potential terminal N of the top-side solar cell string 14 in the solar cell string 10 via the resistor R and the voltmeter Vps, and measures the potential difference Vps-between these terminals NN (negative potential terminal measurement). In a case where the presence or absence of a short circuit can be detected and the location of the short circuit cannot be detected, at least one of positive potential terminal measurement and or negative potential terminal measurement may be performed.

Next, the short-circuit detection device 32 detects whether or not a short circuit has occurred between the bottom-side solar cell submodule 22 and the top-side solar cell submodule 24 in any of the solar cell modules 20 of the solar cell string 10 based on at least one of the potential difference Vps+ or the potential difference Vps-. Specifically, when at least one of the absolute value of the potential difference Vps+ or the absolute value of the potential difference Vps- is 0 V, the short-circuit detection device 32 determines that there is no short circuit between the bottom-side solar cell submodule 22 and the top-side solar cell submodule 24 in any of the solar cell modules 20 in the solar cell string 10.

On the other hand, when at least one of the absolute value of the potential difference Vps+ or the absolute value of the potential difference Vps- is larger than 0 V, the short-circuit detection device 32 detects a short circuit between the bottom-side solar cell submodule 22 and the top-side solar cell submodule 24 in any of the solar cell modules 20 of the solar cell string 10.

Here, for example, when the voltage of each solar cell module 20 is known in advance by shipping inspection or the like, the location of the short circuit in the solar cell string 10 can be estimated. Specifically, the short-circuit detection device 32 identifies the location of the short circuit in the solar cell string 10 based on the potential difference Vps+, the potential difference Vps-, and the measurement values of the voltages of the bottom-side solar cell submodule 22 and the top-side solar cell submodule 24 in each solar cell module 20 stored in advance in the storage unit 36.

On the other hand, when the voltage of each solar cell module 20 is unknown, the location of the short circuit in the solar cell string 10 can be estimated from the ratio of the absolute value of the potential difference Vps+ to the absolute value of the potential difference Vps-. Specifically, the short-circuit detection device 32 may calculate the ratio of the absolute value of the potential difference Vps+ to the absolute value of the potential difference Vps-, and output the calculated ratio to the maintenance manager as a reference of the short circuit location in the solar cell string 10. As an output method, the calculated ratio may be transmitted by the communication unit 37 or displayed by the display unit 38.

Hereinafter, a specific example will be described with reference to FIGS. 3 and 4. In FIGS. 3 and 4, the number M of the solar cell modules 20 in the solar cell string 10 is 5. That is, the number M of the bottom-side solar cell submodules 22 in the bottom-side solar cell string 12 is 5, and the number M of the top-side solar cell submodules 24 in the top-side solar cell string 14 is 5. In addition, the bottom-side solar cell submodule 22 and the top-side solar cell submodule 24 in the second solar cell module 20 from the positive potential terminal P side of the solar cell string 10 are short-circuited.

In addition, the voltages of the bottom-side solar cell submodule 22 and the top-side solar cell submodule 24 in the m-th solar cell module 20 from the positive potential terminal P side of the solar cell string 10 are as follows.
m=1

Voltage of the top-side solar cell submodule 24: 33 V
Voltage of the bottom-side solar cell submodule 22: 10 V
m=2
Voltage of the top-side solar cell submodule 24: 20 V/10 V (/ is a short-circuit location)
Voltage of the bottom-side solar cell submodule 22: 4 V/8 V (/ is a short-circuit location) m=3
Voltage of the top-side solar cell submodule 24: 31 V
Voltage of the bottom-side solar cell submodule 22: 11 V
m=4
Voltage of the top-side solar cell submodule 24: 34 V
Voltage of the bottom-side solar cell submodule 22: 13 V
m=5
Voltage of the top-side solar cell submodule 24: 32 V
Voltage of the bottom-side solar cell submodule 22: 11 V

From FIGS. 3 and 4, the potential difference Vps+ and the potential difference Vps- are measured as follows.

$$\text{Vps+}=(33\ V\ +\ 20\ V)-(10\ V\ +\ 4\ V)=\ 39\ V$$

Vps-=(-32 V - 34 V - 31 V - 10 V)-(-11 V - 13 V - 11 V - 8 V)= -64 V

Accordingly, since the absolute value of the potential difference Vps+ and the absolute value of the potential difference Vps- are larger than 0 V, the short-circuit detection device 32 detects a short circuit between the bottom-side solar cell submodule 22 and the top-side solar cell submodule 24 in any of the solar cell modules 20 of the solar cell string 10.

Here, for example, when the voltage of each solar cell module 20 is known in advance by shipping inspection or the like, the location of the short circuit in the solar cell string 10 can be estimated. Specifically, it can be estimated that the short-circuit location is present in the solar cell module 20 of m = 2 of the solar cell string 10 from the absolute value of the potential difference Vps+ based on the measurement values of the voltages of the bottom-side solar cell submodule 22 and the top-side solar cell submodule 24 in each solar cell module 20 stored in advance in the storage unit 36. Further, it can be estimated that the short-circuit location is present in the solar cell module 20 of m = 2 of the solar cell string 10 from the absolute value of the potential difference Vps - based on the measurement values of the voltages of the bottom-side solar cell submodule 22 and the top-side solar cell submodule 24 in each solar cell module 20 stored in advance in the storage unit 36. In this manner, the short-circuit detection device 32 identifies the location of the short circuit in the solar cell string 10. The short-circuit detection device 32 can also identify the short-circuit location of the cell in the solar cell module 20 in the solar cell string 10.

On the other hand, when the voltage of each solar cell module 20 is unknown, the location of the short circuit in the solar cell string 10 can be estimated from the ratio of the absolute value of the potential difference Vps+ to the absolute value of the potential difference Vps-. Specifically, the short-circuit detection device 32 calculates a ratio |Vps+|/(|Vps +|+| Vps-|) between the absolute value of the potential difference Vps+ and the absolute value of the potential difference Vps-. For example, assuming that the voltages of the solar cell modules 20 are substantially the same, it can be estimated that:

when the ratio is less than 0.2, the solar cell module 20 with m = 1 has a short-circuit location;

when the ratio is 0.2 or more and less than 0.4, the solar cell module 20 with m = 2 has a short-circuited location; when the ratio is 0.4 or more and less than 0.6, the solar cell module 20 with m = 3 has a short-circuit location; when the ratio is 0.6 or more and less than 0.8, the solar cell module 20 with m = 4 has a short-circuit location; and when the ratio is 0.8 or more and less than 1.0, the solar cell module 20 with m = 5 has a short-circuit location.

In this way, the location of the short circuit in the solar cell string 10 can be estimated. In addition, it is possible to estimate a short-circuit location of a cell in the solar cell module 20 in the solar cell string 10.

In this way, the short-circuit detection device 32 may output the calculated ratio |Vps+| / (|Vps+| + |Vps-|) to the maintenance manager as a reference of the short-circuit location in the solar cell string 10. The short-circuit detection device 32 may output the calculated ratio |Vps+|/(|Vps+|+|Vps-|) as a percentage.

Similarly, the short-circuit detection device 32 may calculate a ratio |Vps-|/(|Vps+|+|Vps-|) between the absolute value of the potential difference Vps+ and the absolute value of the potential difference Vps-, and output the calculated ratio |Vps-|/(|Vps+|+|Vps-|) to the maintenance manager as a reference of the short-circuit location in the solar cell string 10. In addition, the short-circuit detection device 32 may output the calculated ratio |Vps-|/(|Vps+|+|Vps-|) as a percentage.

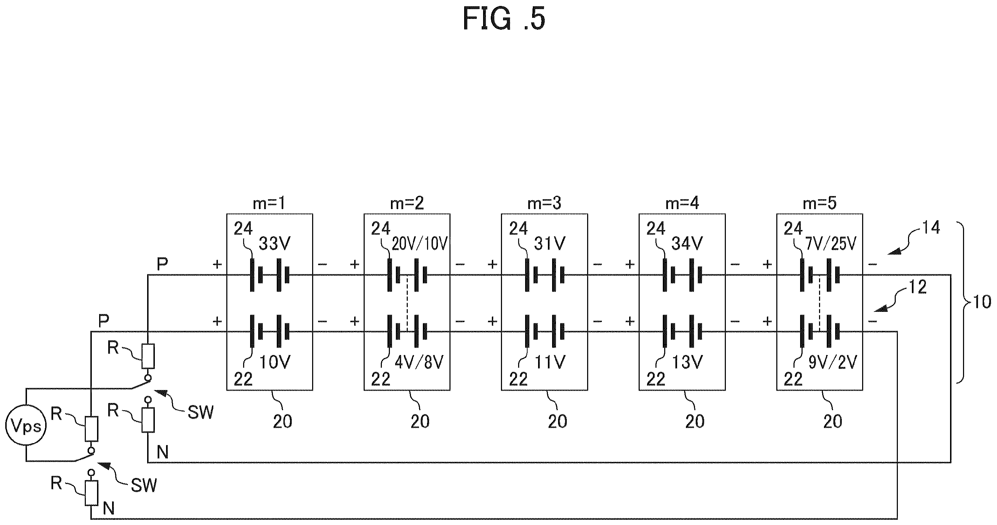

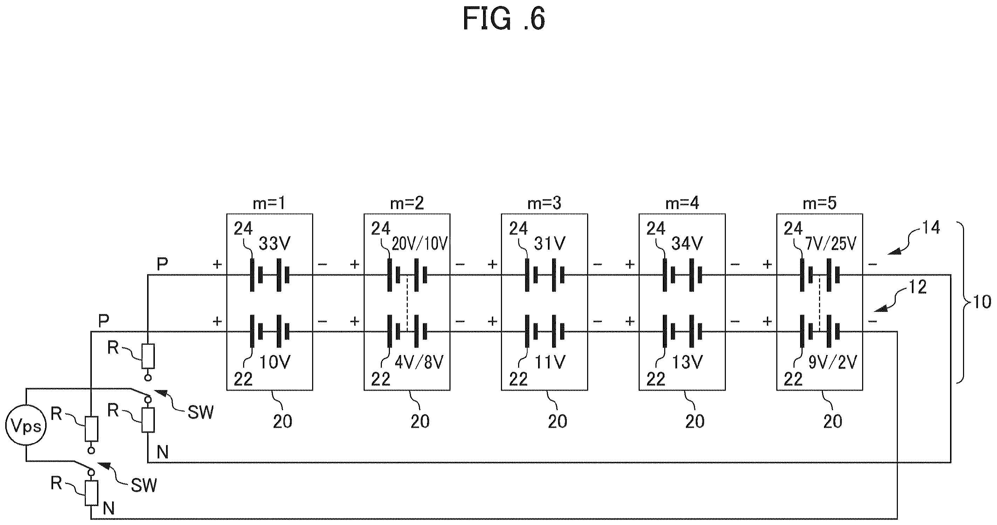

According to the above-described method of detecting a short circuit in the solar cell string 10 by the short-circuit detection device 32, not only a one point short circuit but also a two point short circuit can be detected. FIGS. 5 and 6 are diagrams each showing a solar cell string in the solar power generation system shown in FIG. 1. In FIGS. 5 and 6, in addition to FIGS. 3 and 4, the bottom-side solar cell submodule 22 and the top-side solar cell submodule 24 in the fifth solar cell module 20 from the positive potential terminal P side of the solar cell string 10 are also short-circuited. The voltages of the bottom-side solar cell submodule 22 and the top-side solar cell submodule 24 in the solar cell module 20 in which m = 5 are as follows.

m=5

Voltage of the top-side solar cell submodule 24: 7 V/25 V (/ is a short-circuit location)
Voltage of the bottom-side solar cell submodule 22: 9 V/2 V (/ is a short-circuit location)

From FIGS. 5 and 6, the potential difference Vps+ and the potential difference Vps- are measured as follows.

$$\mathtt{Vps(+) = (33\ V\ +\ 20\ V) - (10\ V\ +\ 4\ V)\ =\ 39\ V}$$

$$\mathtt{Vps(-) = (-25\ V) - (-2\ V)\ =\ -23\ V}$$

Here, for example, in a case where the number M of solar cell modules 20 and the voltage of each solar cell module 20 are known in advance by shipping inspection or the like, it is possible to detect the presence or absence of the two-point short circuit in the solar cell string 10. Specifically, based on the number M of the solar cell modules 20 stored in advance in the storage unit 36 and the measured values of the voltages of the bottom-side solar cell submodule 22 and the top-side solar cell submodule 24 in each solar cell module 20, the short-circuit detection device 32 can detect a two-point short circuit in the solar cell string 10 when the sum of the absolute value of the potential difference Vps+ and the absolute value of the potential difference Vps- is smaller than the sum of the measured values of m = 1 to 5.

In addition, it can be estimated that the first short-circuit location is present in the solar cell module 20 of m = 2 of the solar cell string 10 from the absolute value of the potential difference Vps+ based on the measurement values of the voltages of the bottom-side solar cell submodule 22 and the top-side solar cell submodule 24 in each solar cell module 20 stored in advance in the storage unit 36. Further, it can be estimated that the second short-circuit point is present in the solar cell module 20 of m = 5 of the solar cell string 10 from the absolute value of the potential difference Vps- based on the measurement values of the voltages of the bottom-side solar cell submodule 22 and the top-side solar cell submodule 24 in each solar cell module 20 stored in advance in the storage unit 36. In this way, the short-circuit detection device 32 identifies the location of the two-point short circuit in the solar cell string 10. Furthermore, the short-circuit detection device 32 can also identify a two-point short circuit location of a cell in the solar cell module 20 in the solar cell string 10.

As described above, according to the solar power generation system 1 and the method of detecting a short circuit of a solar power generation system of the first embodiment, it is possible to detect the presence or absence of a short circuit between the bottom-side solar cell submodule 22 and the top-side solar cell submodule 24 in any of the plurality of tandem solar cell modules 20 of the solar cell string 10, and to identify (estimate) the location of the short circuit.

[Second Embodiment]

(Solar Power Generation System)

In the first embodiment, the configuration in which M number of top-side solar cell submodules 24 of M number of solar cell modules 20 are connected in series in the top-side solar cell string 14 of the solar cell string 10 has been described. In the second embodiment, a configuration in which M number of top-side solar cell submodules 24 of M solar cell modules 20 are connected in parallel in the top-side solar cell string 14 of the solar cell string 10 will be described. Although a description for the case where M number of bottom-side solar cell submodules 22 of M number of solar cell modules 20 are connected in parallel in the bottom-side solar cell string 12 of the solar cell string 10 is omitted, it can be considered the same for this case.

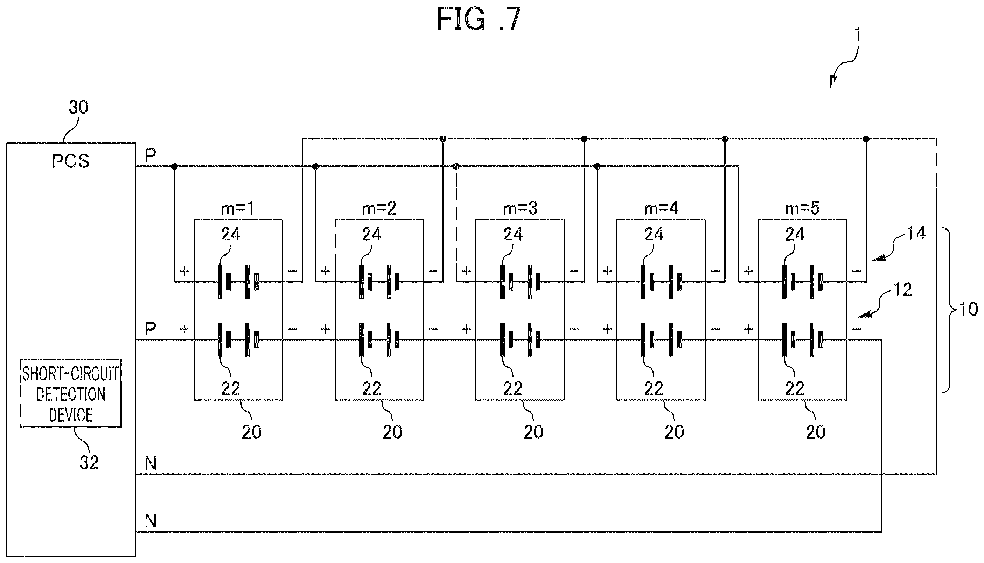

FIG. 7 is a schematic diagram showing a configuration of a solar power generation system according to a second embodiment. The solar power generation system 1 according to the second embodiment shown in FIG. 7 is different from the solar power generation system 1 according to the first embodiment shown in FIG. 1 in the connection configuration of the top-side solar cell string 14 of the solar cell string 10. The other configurations of the solar power generation system 1 according to the second embodiment are the same as those of the solar power generation system 1 according to the first embodiment.

As shown in FIG. 7, in the solar cell string 10, M number of top-side solar cell submodules 24 of M number of solar cell modules 20 constitute the top-side solar cell string 14 connected in parallel between the other positive potential terminal P and the other negative potential terminal N.

For example, a thin-film solar cell submodule such as a perovskite-type thin-film solar cell submodule is constituted by a plurality of thin-film solar battery cells that are divided or segmented in a first direction (integration direction), extend in a second direction intersecting the first direction on one base material, and are integrated by connecting in series. In this case, since the solar cell submodules have a relatively high voltage, the solar cell submodules may be connected in parallel in the solar cell string.

(Short Circuit Detection Method)

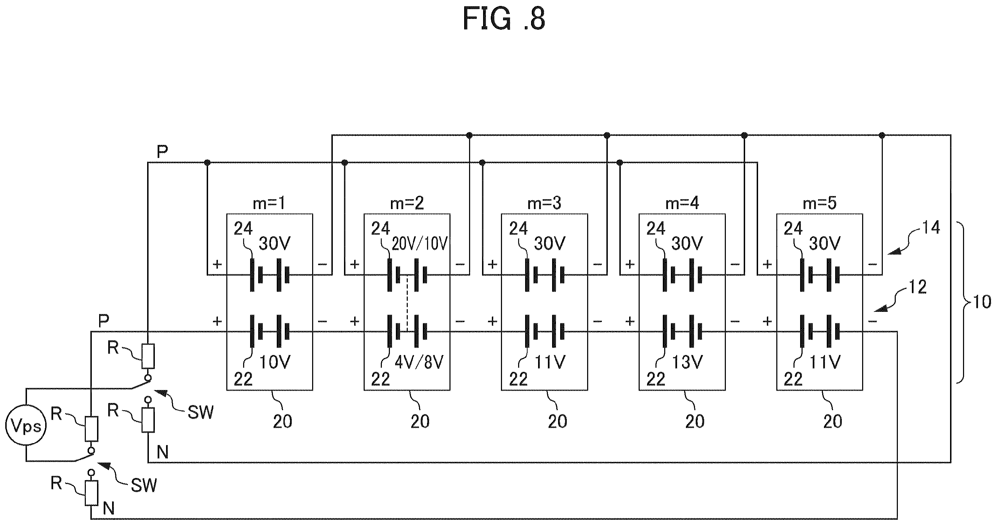

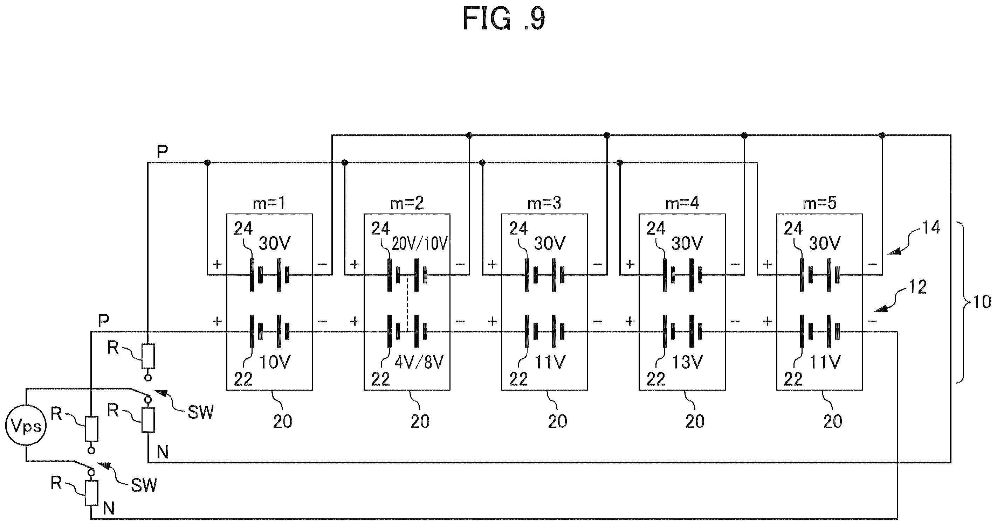

In the second embodiment, as in the first embodiment, the short circuit of the solar cell string 10 can be detected by the short-circuit detection device 32. FIGS. 8 and 9 are diagrams each showing a solar cell string in the solar power generation system shown in FIG. 7.

First, as shown in FIG. 8, the short-circuit detection device 32 electrically connects the positive potential terminal P of the bottom-side solar cell string 12 and the positive potential terminal P of the top-side solar cell string 14 in the solar cell string 10 via the resistors R and the voltmeter Vps, and measures the potential difference Vps+ between these terminals PP (positive potential terminal measurement).

Next, as shown in FIG. 9, the short-circuit detection device 32 electrically connects the negative potential terminal N of the bottom-side solar cell string 12 and the negative potential terminal N of the top-side solar cell string 14 in the solar cell string 10 via the resistors R and the voltmeter Vps, and measures the potential difference Vps-between these terminals NN (negative potential terminal measurement). In addition, in the case of detecting only the presence or absence of a short circuit as described above, at least one of the positive potential terminal measurement or the negative potential terminal measurement may be performed.

Next, the short-circuit detection device 32 detects presence or absence of a short circuit has occurred between the bottom-side solar cell submodule 22 and the top-side solar cell submodule 24 in any of the solar cell modules 20 of the solar cell string 10 based on at least one of the potential difference Vps+ or the potential difference Vps-. Specifically, when at least one of the absolute value of the potential difference Vps+ or the absolute value of the potential difference Vps- is 0 V, the short-circuit detection device 32 determines that there is no short-circuit between the bottom-side solar cell submodule 22 and the top-side solar cell submodule 24 in any of the solar cell modules 20 in the solar cell string 10.

On the other hand, when at least one of the absolute value of the potential difference Vps+ or the absolute value of the potential difference Vps- is larger than 0 V, the short-circuit detection device 32 detects a short circuit between the bottom-side solar cell submodule 22 and the top-side solar cell submodule 24 in any of the solar cell modules 20 of the solar cell string 10.

From FIGS. 8 and 9, the potential difference Vps+ and the potential difference Vps- are measured as follows.

$$\mathrm{Vps+=(20\ V)-(10\ V\ +\ 4\ V)\ =\ 6\ V}$$

$$\mathrm{Vps-=(-10\ V)\ -\ (-11\ V\ -\ 13\ V\ -11\ V\ -\ 8\ V)\ =\ 33\ V}$$

Accordingly, since the absolute value of the potential difference Vps+ and the absolute value of the potential difference Vps- are larger than 0 V, the short-circuit detection device 32 detects a short circuit between the bottom-side solar cell submodule 22 and the top-side solar cell submodule 24 in any of the solar cell modules 20 of the solar cell string 10.

In this way, even when the plurality of tandem solar cell modules 20 are connected in parallel in the solar cell string 10, it is possible to detect the presence or absence of a short circuit between the bottom-side solar cell submodule 22 and the top-side solar cell submodule 24 in any of the plurality of tandem solar cell modules 20 of the solar cell string 10.

Although embodiments of the present invention have been described above, the present invention is not limited to the above-described embodiments, and various changes and modifications thereto can be made. For example, in the above-described embodiments, the configuration has been exemplified in which, in the short-circuit detection device 32 and the short-circuit detection method, the positive potential terminal P of the bottom-side solar cell string 12 and the positive potential terminal P of the top-side solar cell string 14 in the solar cell string 10 are electrically connected to each other via the resistors R and the voltmeter Vps, and the potential difference Vps+ between these terminals PP is measured (positive potential terminal measurement). However, the present invention is not limited thereto, and in the short-circuit detection device 32 and the short circuit detection method, the positive potential terminal P of the bottom-side solar cell string 12 and the negative potential terminal N of the top-side solar cell string 14 in the solar cell string 10 may be electrically connected to each other via the resistors R and the voltmeter Vps, and the potential difference Vps+ between these terminals PN may be measured (positive potential terminal measurement).

Further, in the above-described embodiments, the configuration has been exemplified in which, in the short-circuit detecting device 32 and the short-circuit detecting method, the negative potential terminal N of the bottom-side solar cell string 12 and the negative potential terminal N of the top-side solar cell string 14 in the solar cell string 10 are electrically connected to each other via the resistors R and the voltmeter Vps, and the potential difference Vps- between these terminals NN is measured (negative potential terminal measurement). However, the present invention is not limited thereto, and in the short-circuit detection device 32 and the short circuit detection method, the negative potential terminal N of the bottom-side solar cell string 12 and the positive potential terminal P of the top-side solar cell string 14 in the solar cell string 10 may be electrically connected to each other via the resistors R and the voltmeter Vps, and the potential difference Vps- between these terminals NP may be measured (negative potential terminal measurement).

Even in these configurations, similarly to the above, it is possible to detect the presence or absence of a short circuit between the bottom-side solar cell submodule 22 and the top-side solar cell submodule 24 in any of the plurality of tandem solar cell modules 20 of the solar cell string 10 based on at least one of the potential difference Vps+ or the potential difference Vps-, and it is possible to identify (estimate) the location of the short circuit.

EXPLANATION OF REFERENCE NUMERALS

1.      solar power generation system
10.     solar cell string
12.     bottom-side solar cell string
14.     top-side solar cell string
20.     solar cell module
22.     bottom-side solar cell submodule
24.     top-side solar cell submodule
30.     power conditioner
32.     short-circuit detection device
35.     control unit
36.     storage unit
37.     communication unit
38.     display unit
R.      resistor
SW.     switch

**Claims**

**1.**  A solar power generation system comprising:

a solar cell string in which M number of 4-terminal tandem solar cell modules each including a bottom-side solar cell submodule and a top-side solar cell submodule are electrically connected, where M is an integer of 1 or more; and
a short-circuit detection device that detects a short circuit between the bottom-side solar cell submodule and the top-side solar cell submodule in any of the M number of tandem solar cell modules of the solar cell string, wherein in the solar cell string,

M number of bottom-side solar cell submodules in the M number of tandem solar cell modules constitute a bottom-side solar cell string connected in series or in parallel, and

M number of top-side solar cell submodules in the M number of tandem solar cell modules constitute a top-side solar cell string connected in series or in parallel, and

wherein the short-circuit detection device performs at least one of

a positive potential terminal measurement which electrically connects a positive potential terminal of the bottom-side solar cell string and a positive potential terminal or a negative potential terminal of the top-side solar cell string and measures a potential difference Vps+ between these terminals, or

a negative potential terminal measurement which electrically connects a negative potential terminal of the bottom-side solar cell string and the negative potential terminal or the positive potential terminal of the top-side solar cell string and measures a potential difference Vps-between these terminals, and

wherein the short-circuit detection device further detects, when at least one of an absolute value of the potential difference Vps+ or an absolute value of the potential difference Vps- is larger than 0 V, a short circuit between the bottom-side solar cell submodule and the top-side solar cell submodule in any of the M number of tandem solar cell modules.

**2.** The solar power generation system according to claim 1, wherein the short-circuit detection device further comprises a storage unit that stores measurement values of voltages of the M number of bottom-side solar cell submodules and voltages of the M number of top-side solar cell submodules measured in advance, and

the short-circuit detection device identifies a location of a short circuit in the solar cell string based on the potential difference Vps+, the potential difference Vps-, and a measurement value stored in advance in the storage unit.

**3.** The solar power generation system according to claim 1, wherein the short-circuit detection device identifies a location of a short circuit in the solar cell string based on a ratio of an absolute value of the potential difference Vps+ to an absolute value of the potential difference Vps-.

**4.** A method of detecting a short circuit in a solar power generation system, the solar power generation system including a solar cell string in which M number of 4-terminal tandem solar cell modules each including a bottom-side solar cell submodule and a top-side solar cell submodule are electrically connected,

in the solar cell string,

M number of bottom-side solar cell submodules in the M number of tandem solar cell modules constituting a bottom-side solar cell string connected in series or in parallel, and

M number of top-side solar cell submodules in the M number of tandem solar cell modules constituting a top-side solar cell string connected in series or in parallel, where M is an integer of 1 or more,

the method comprising:

performing at least one of

a positive potential terminal measurement of electrically connecting a positive potential terminal of the bottom-side solar cell string and a positive potential terminal or a negative potential terminal of the top-side solar cell string and measuring a potential difference Vps+ between these terminals, or

a negative potential terminal measurement of electrically connecting a negative potential terminal of the bottom-side solar cell string and a negative potential terminal or the positive potential terminal of the top-side solar cell string and measuring a potential difference Vps-between these terminals; and

detecting, when at least one of an absolute value of the potential difference Vps+ or an absolute value of the potential difference Vps- is larger than 0 V, a short circuit between the bottom-side solar cell submodule and the top-side solar cell submodule in any of the M number of tandem solar cell modules.

**5.** The method of detecting a short circuit in a solar power generation system according to claim 4, further comprising: storing measured values of voltages of the M number of bottom-side solar cell submodules and voltages of the M number of top-side solar cell submodules measured in advance; and
identifying a location of a short circuit in the solar cell string based on the potential difference Vps+, the potential difference Vps-, and a measurement value stored in advance.

**6.** The method of detecting a short circuit in a solar power generation system according to claim 4, further comprising identifying a location of a short circuit in the solar cell string based on a ratio of an absolute value of the potential difference Vps+ to an absolute value of the potential difference Vps-.

# FIG .1

# FIG .2

32

SHORT-CIRCUIT DETECTION DEVICE

GROUND FAULT DETECTION CIRCUIT

R

SW

Vp

R

P(14)

N(14)

CONTROL UNIT ~35

STORAGE UNIT ~36

COMMUNICATION UNIT ~37

DISPLAY UNIT ~38

Vps

GROUND FAULT DETECTION CIRCUIT

R

SW

Vs

R

P(12)

N(12)

FIG .3

FIG .4

FIG .5

FIG .6

EP 4 693 894 A1

FIG .7

FIG.8

FIG .9

## INTERNATIONAL SEARCH REPORT

| International application No. |
| --- |
| **PCT/JP2024/010161** |

**A.  CLASSIFICATION OF SUBJECT MATTER**

*H02S 50/00*(2014.01)i; *G01R 31/50*(2020.01)i; *G01R 31/52*(2020.01)i; *G01R 31/56*(2020.01)i; *H01L 31/043*(2014.01)i
FI:   H02S50/00; G01R31/50; G01R31/52; G01R31/56; H01L31/04 510

According to International Patent Classification (IPC) or to both national classification and IPC

**B.  FIELDS SEARCHED**

Minimum documentation searched (classification system followed by classification symbols)

H02S50/00; G01R31/50; G01R31/52; G01R31/56; H01L31/04-31/078

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C.  DOCUMENTS CONSIDERED TO BE RELEVANT**

| Category* | Citation of document, with indication, where appropriate, of the relevant passages | Relevant to claim No. |
| --- | --- | --- |
| A | WO 2022/259461 A1 (KABUSHIKI KAISHA TOSHIBA) 15 December 2022 (2022-12-15) entire text, all drawings | 1-6 |
| A | JP 2011-155225 A (DAINIPPON SCREEN MFG. CO., LTD.) 11 August 2011 (2011-08-11) entire text, all drawings | 1-6 |
| A | JP 2010-073990 A (MITSUBISHI HEAVY INDUSTRIES, LTD.) 02 April 2010 (2010-04-02) entire text, all drawings | 1-6 |
| A | WO 2021/124607 A1 (MITSUBISHI ELECTRIC CORPORATION) 24 June 2021 (2021-06-24) entire text, all drawings | 1-6 |
| A | WO 2019/150777 A1 (SUMITOMO ELECTRIC INDUSTRIES, LTD.) 08 August 2019 (2019-08-08) entire text, all drawings | 1-6 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **09 April 2024** | **23 April 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**

| International application No. |
| :-- |
| **PCT/JP2024/010161** |

## C.    DOCUMENTS CONSIDERED TO BE RELEVANT

| Category* | Citation of document, with indication, where appropriate, of the relevant passages | Relevant to claim No. |
| :-: | :-- | :-: |
| A | WO 2017/187636 A1 (MITSUBISHI ELECTRIC CORPORATION) 02 November 2017 (2017-11-02) entire text, all drawings | 1-6 |

Form PCT/ISA/210 (second sheet) (July 2022)

**INTERNATIONAL SEARCH REPORT**
Information on patent family members

| International application No. |
|---|
| **PCT/JP2024/010161** |

| Patent document cited in search report | | | Publication date (day/month/year) | Patent family member(s) | | | Publication date (day/month/year) |
|---|---|---|---|---|---|---|---|
| WO | 2022/259461 | A1 | 15 December 2022 | US | 2023/0231065 | A1 | |
| | | | | CN | 115917763 | A | |
| JP | 2011-155225 | A | 11 August 2011 | (Family: none) | | | |
| JP | 2010-073990 | A | 02 April 2010 | (Family: none) | | | |
| WO | 2021/124607 | A1 | 24 June 2021 | CN | 114846743 | A | |
| WO | 2019/150777 | A1 | 08 August 2019 | DE | 112018007008 | T | |
| WO | 2017/187636 | A1 | 02 November 2017 | US | 2019/0103832 | A1 | |
| | | | | CN | 109075741 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016101012 A
- JP 2018157176 A